# EUROPEAN PATENT APPLICATION

(11) **EP 1 531 658 A1**
(43) Date of publication of application: **18.05.2005**
(21) Application number: 04025925.1
(22) Date of filing: 02.11.2004
(51) Int. Cl.: H05K 3/42

(54) **Double sided wired circuit board**

(30) Priority: 13.11.2003 JP 2003383228
(71) Applicant: NITTO DENKO CORPORATION, Ibaraki-shi, Osaka 567-8680 (JP)
(72) Inventor: Naito, Toshiki, Ibaraki-shi Osaka 567-8680 (JP); Yoshimi, Takeshi, Ibaraki-shi Osaka 567-8680 (JP)
(74) Representative: Schwabe - Sandmair - Marx

(57) **Abstract**

A double sided wired circuit board that can permit forming of wiring circuit pattern over the through hole and mounting of the electronic component thereon, for high-density forming of the wiring circuit pattern and high-density mounting of the electronic component. In the double sided wired circuit board comprising an insulating layer 1, and conductor layers 3 formed on both sides of the insulating layer 1, a through hole 2 extending in a thickness direction of the insulating layer 1 is formed in the insulating layer 1 and then the through hole 2 is filled with copper with no substantial space therein by electrolytic plating, to form a conductor portion 4 for providing the electrical conduction between the conductor layers 3. This can permit areas on the surface of the conductor portion to be used as a component mounting portion. This can allow the wiring circuit patterns of the conductor layers 3 to be formed on the component mounting portion and can allow the electronic component to be mounted thereon, thus achieving high-density forming of the wiring circuit pattern and high-density mounting of the electronic component.

## Description

### BACKGROUND OF THE INVENTION

### Field of the Invention

The present invention relates to a double sided wired circuit board and, more particularly, to a double sided wired circuit board with conductor layers formed on both sides of an insulating layer.

### Description of the Prior Art

The double sided flexible wired circuit board is a wired circuit board having wiring circuit patterns of a copper foil and the like formed on both sides of an insulating substrate of polyimide resin and the like.

In this double sided flexible wired circuit board, it is usual that a through hole is formed in the insulating substrate to provide electrical conduction between the wired circuit patterns and a through hole plating is formed on an inside surface of the through hole.

For example, JP Laid-open (Unexamined) Patent Publication No. Hei 5-136562 proposes an elongate flexible board wherein metal foils used to form conductor circuits are integrally formed on both sides of the insulating substrate, and the conductor circuits formed on the both sides of the insulating substrate are electrically connected via the through hole.

Meanwhile, high-density forming of the wiring circuit pattern and high-density mounting of the electronic components are increasingly demanded for the wired circuit board. The through hole is plated in the ring-like form to extend along the inner circumference by the through hole plating, such that the through hole is hollow at a center thereof and is not filled with the plating material. Due to this, it is hard to form the wiring circuit pattern over the through hole and mount the electronic component thereon.

### SUMMARY OF THE INVENTION

It is the object of the invention to provide a double sided wired circuit board that can permit forming of wiring circuit pattern over the through hole and mounting of the electronic component thereon, for high-density forming of the wiring circuit pattern and high-density mounting of the electronic component.

The present invention provides a double sided wired circuit board comprising an insulating layer, and conductor layers formed on both sides of the insulating layer, wherein a through hole extending in a thickness direction of the insulating layer is formed in the insulating layer, and wherein the through hole is filled with a metal.

In the double sided wired circuit board of the present invention, it is preferable that the metal is formed by electrolytic plating.

In the double sided wired circuit board of the present invention, an end of the metal filled in the through hole can serve as a component mounting portion.

According to the double sided wired circuit board of the present invention, since the through hole is filled with a metal, the end of the metal can be used as a component mounting portion, and as such can allow the forming of the wiring circuit pattern on the component mounting portion or the mounting of electronic component thereon. This can provide enhancement of the high-density forming of the wiring circuit pattern and high-density mounting of the electronic component.

### BRIEF DESCRIPTION OF THE DRAWINGS

In the drawings:

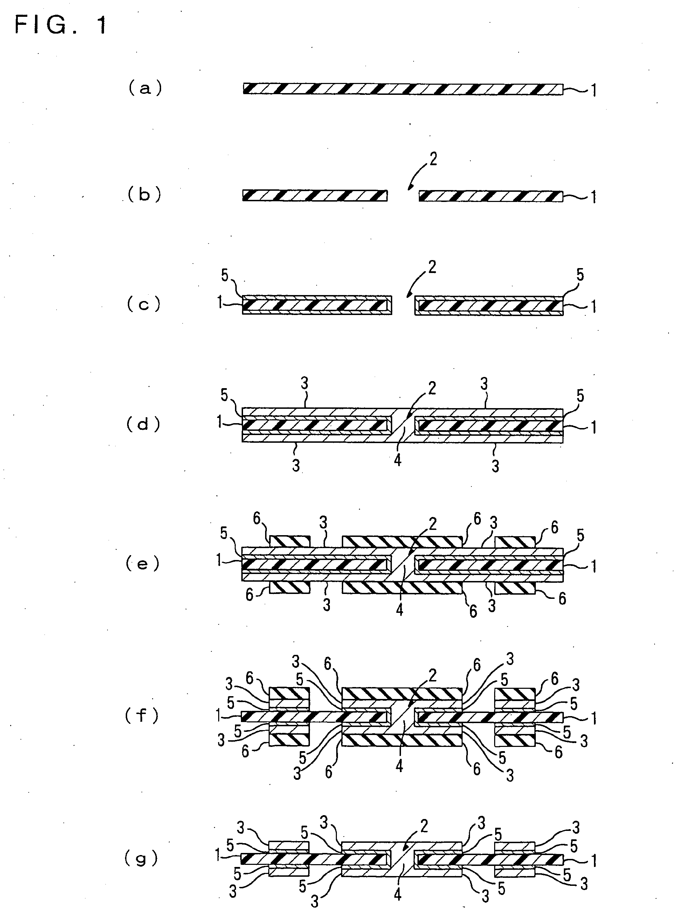

FIG. 1 is a production process drawing of a double sided flexible wired circuit board as a first embodiment of a double sided wired circuit board of the present invention:
   (a) shows the process of preparing an insulating layer;
   (b) shows the process of forming a through hole in the insulating layer;
   (c) shows the process of forming a thin metal film on both sides of the insulating layer and around the inside of the through hole;
   (d) shows the process of forming conductor layers on the thin metal films formed on both sides of the insulating layer and forming a conductor portion to be filled in an interior space surrounded by the thin metal film formed around the inside surface of the through hole:
   (e) shows the process of forming an etching resist in the same pattern as the wiring circuit pattern on each of the conductor layers;
   (f) shows the process of etching the conductor layers exposed from the etching resists; and
   (g) shows the process of removing the etching resists.

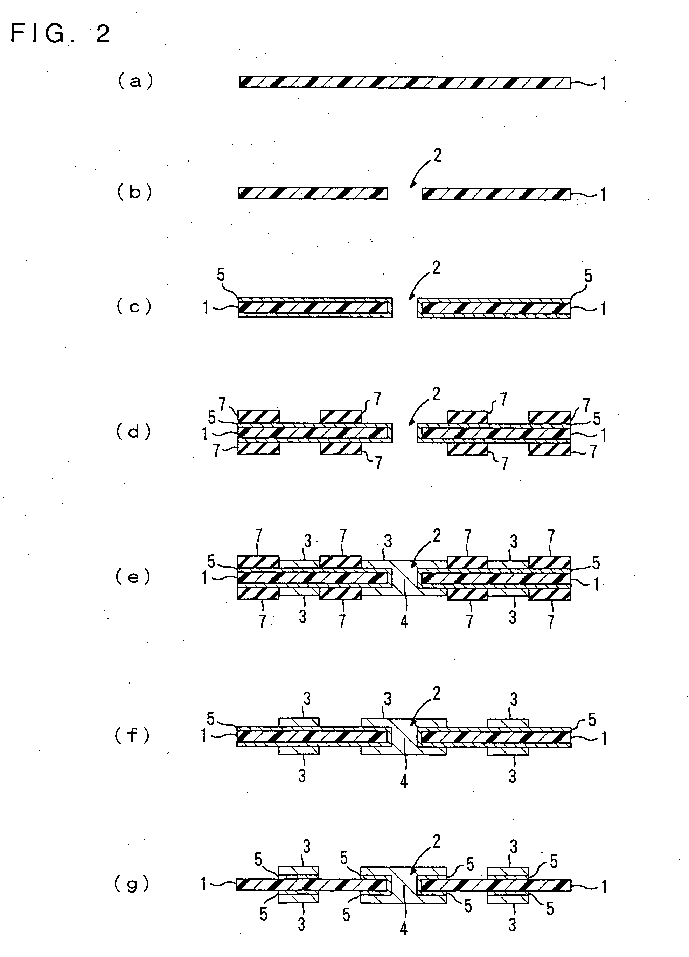

FIG. 2 is a production process drawing of a double sided flexible wired circuit board as a second embodiment of a double sided wired circuit board of the present invention:
   (a) shows the process of preparing an insulating layer;
   (b) shows the process of forming a through hole in the insulating layer;
   (c) shows the process of forming thin metal films on both sides of the insulating layer and around the inside of the through hole;
   (d) shows the process of forming a plating resist in the form of a pattern inverted to the wiring circuit pattern on each of the thin metal films formed on the both sides of the insulating layer;
   (e) shows the process of forming conductor layers on the thin metal films exposed from the plating resists and forming a conductor portion to be filled in an interior space surrounded by the thin metal film formed around the inside surface of the through hole:
   (f) shows the process of removing the plating resist to form the conductor layer in the form of the wiring circuit pattern;
   (g) shows the process of removing the thin metal film from the whole area of the insulating layer except the area thereof where the conductor layer and the conductor portion are formed.

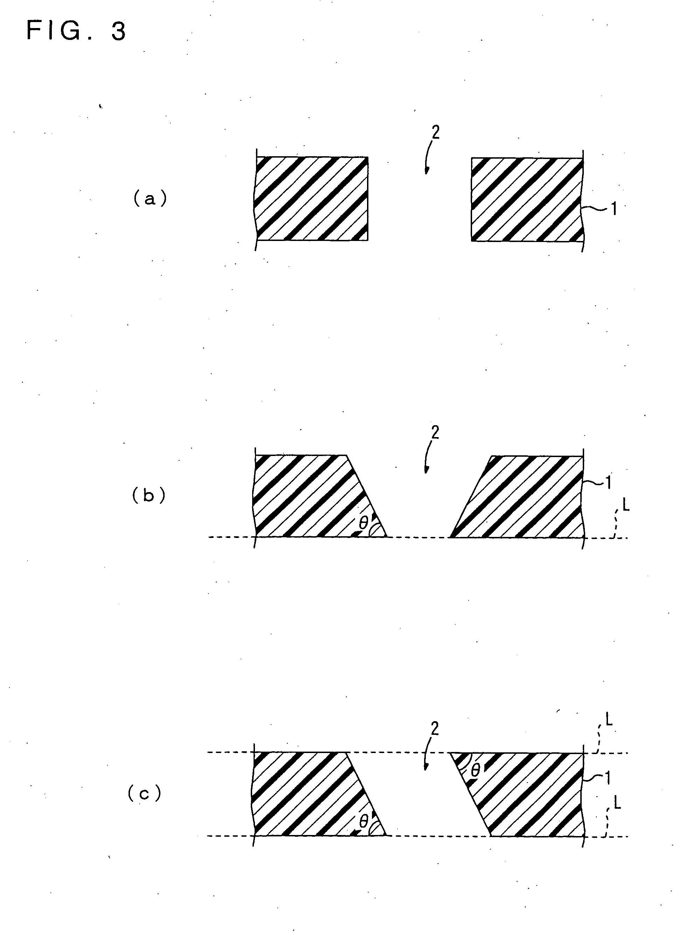

FIG. 3 is enlarged sectional views showing principal parts of configurations of the through holes formed in the insulating layer:
   (a) shows a configuration of the through hole formed to extend along a direction perpendicular to a longitudinal direction of the insulating layer;
   (b) shows a configuration of the through hole configured in a tapered form that it becomes narrower gradually from one side of the insulating layer to the other side of the same; and
   (c) shows a configuration of the through hole formed to obliquely extend with respect to the longitudinal direction of the insulating layer and the direction perpendicular to the longitudinal direction of the same.

### DETAILED DESCRIPTION OF THE PREFERRED EMBODIMENTS

Shown in FIG. 1 is a production process drawing of a double sided flexible wired circuit board as a first embodiment of a double sided wired circuit board of the present invention. Referring to FIG. 1, the production method of the first embodiment of the double sided flexible wired circuit board will be described, first.

In this method, an insulating layer 1 is prepared, first, as shown in FIG. 1(a). Any material may be used for the insulating layer 1 without any particular limitation, as long as it can be used for the insulating layer of a flexible wired circuit board. For example, a synthetic resin film can be used as the insulating layer 1. The synthetic resin films that may be used include, for example, a polyimide resin film, polyamideimide resin film, an acrylic resin film, a polyether nitrile resin film, a polyether sulfonic resin film, a polyethylene terephthalate resin film, a polyethylene naphthalate resin film, and a polyvinyl chloride resin film. Preferably, the polyimide resin film is used as the first insulating layer 1.

The first insulating layer 1 has a thickness of e.g. 5-500µm, or preferably 10-50µm.

Then, a through hole 2 extending through the insulating layer 1 in a thickness direction thereof is formed in the insulating layer 1, as shown in FIG. 1(b). No particular limitation is imposed on the method of forming the through hole 2. The through hole 2 can be formed by a known method, including machining such as drilling and punching, laser processing such as a YAG laser or an excimer laser, and a chemical etching. The through hole 2 may be formed simultaneously with the formation of the insulating layer 1 by using photosensitive synthetic resin for the insulating layer 1 and exposing it to light and developing it.

The size and shape of the through hole 2 is properly selected for the intended purposes and applications. For example, when formed in a circular shape, the through hole 2 is formed to have a maximum diameter of 20-300µm, or preferably 30-150µm, in terms of enhancement of high-density forming of the wiring circuit pattern and high-density mounting of the electronic component.

The through hole 2 may be formed to extend along a direction perpendicular to a longitudinal direction of the insulating layer 1 (in a rectangular form in section as viewed from side) by machining and the like, as shown in FIG. 3(a). Alternatively, it may be formed in a tapered form that it becomes narrower gradually (or becomes wider gradually, though not shown) from one side of the insulating layer 1 to the other side of the same (a trapezoidal form in section as viewed from side) by laser processing or by a chemical etching and the like, as shown in FIG. 3(b), or may be formed to obliquely extend with respect to the longitudinal direction of the insulating layer 1 and the direction perpendicular to the longitudinal direction of the same (a parallelogram form in section as viewed from side) by laser processing or by a chemical etching, as shown in FIG. 3(c).

An angle θ of obliquity of the through hole 2 with respect to a reference line L extending along the longitudinal direction of the insulating layer 1 shown in FIG. 3(b) and FIG. 3(c) (along a direction along which a front or back side of the insulating layer 1 extends) is preferably in the range of 40-70°.

When the through hole 2 is formed to extend along the perpendicular direction to the longitudinal direction of the insulating layer 1), so that the inside surface thereof extends vertically with respect to the longitudinal direction of the same, as shown in FIG. 3(a), there may be cases where it becomes hard to form the thin metal film 5 mentioned later by sputtering. Accordingly, it is preferable that the through hole 2 is formed in a tapered form shown in FIG. 3(b) or in an obliquely extending form shown in FIG. 3(c). In the case where the through hole 2 is formed obliquely, as shown in FIG. 3(c), thin metal films 5 are formed on both sides of the insulating layer 1 by sputtering from the both sides of the insulating layer 1.

Thereafter, the conductor layers 3 are formed in the form of the wiring circuit pattern on both sides of the insulating layer 1 by the subtractive process, as shown in FIG. 1(c) to FIG. 1(g). At the same time as the forming of the conductor layers 3, the conductor portion 4 for providing electrical conduction between the conductor layers 3 is formed in the through hole 2 by filling conductive material in the through hole 2 with no substantial space therein.

Specifically, the thin metal films 5 serving as a seed film are formed on the both sides of the insulating layer 1 and around the inside surface of the through hole 2, first, as shown in FIG. 1(c). The thin metal film 5 is formed of chromium, copper, or the like. Preferably, it is formed of copper. The thin metal films 5 are formed, for example, by electroless plating or by sputtering, though no particular limitation on the method of forming the thin metal films 5. Preferably, the thin metal films 5 are formed by sputtering.

The thin metal films 5 have a thickness of e.g. 10nm-3µm, or preferably 50-500nm.

Then, as shown in FIG. 1(d), the conductor layers 3 are formed on the surfaces of the thin metal films 5 formed on both sides of the insulating layer 1 and also the conductor portion 4 is formed to be filled in an interior space surrounded by the thin metal film 5 formed around the inside surface of the through hole 2.

When these conductor layers 3 and conductor portion 4 are formed, the conductor layers 3 are formed on both lengthwise (vertical) ends of the conductor portion 4 as well, so that the both lengthwise (vertical) ends of the conductor portion 4 formed in the through hole 2 are continuous with the respective conductor layers 3.

The conductor layers 3 and the conductor portion 4 are formed of metal such as copper, nickel, gold, solder, or alloys thereof, preferably of copper. The conductor layers 3 and the conductor portion 4 are simultaneously formed by electrolytic plating, or preferably by electrolytic copper plating, though not particularly limited thereto.

In the electrolytic copper plating, for example a copper sulfate solution in which an additive is mixed is used as a plating solution. The additives that may be used include, for example, polyalkylene glycol, such as polyethylene glycol and polypropylene glycol, sulfur-based compounds, such as a thiourate-based compound and a disulfide-based compound, and nitrogenous compounds such as a dye like Janus green. A commercially available plating solution can be used as the plating solution. Also, the current density is set to be in the range of e.g. 0.1-5A/dm², or preferably in the range of 0.5-3A/dm².

Each conductor layer 3 has a thickness of e.g. 3-30µm, or preferably 5-15µm.

Thereafter, an etching resist 6 is formed on the each conductor layer 3 in the same pattern as the wiring circuit pattern, as shown in FIG. 1(e). The etching resist 6 is formed in the resist pattern mentioned above, for example, by a known method of laminating a dry film photoresist on the conductor layer 3; exposing it to light; and developing it. The etching resist 6 is formed in a pattern to cover at least an area on the surface of the conductor portion 4.

Thereafter, the conductor layers 3 exposed from the etching resists 6 are etched, as shown in FIG. 1(f). The etching is carried out by a known etching method such as a chemical etching (wet etching). In this etching process, the thin metal films 5 on which the conductor layers 3 exposed from the etching resists 6 are laminated are also etched.

Then, the etching resists 6 are removed and thereby the conductor layers 3 are produced in the form of the wiring circuit pattern, as shown in FIG. 1(g). The removal of the etching resists 6 is carried out by the known etching method, such as the chemical etching (wet etching) or by stripping.

This can provide the result that the conductor portion 4 is formed in the through hole 2 with no substantial space therein and also formed to be integral with the respective conductor layers 3 in the form of the wiring circuit pattern. This can allow the electrical connection between the conductor layers 3 via the conductor portion 4.

Also, in the double sided wired circuit board thus produced, the through hole 2 is solidly filled with the conductor portion 4 (or is filled to opening cross sectional portion thereof with the conductor portion 4). This can allow the both lengthwise (vertical) ends of the conductor portion 4 to be used as component mounting portions, and as such can allow the forming of the wiring circuit pattern of the conductor layers 3 on the component mounting portions, as in the first embodiment, or the mounting of electronic components thereon, not shown. This can provide enhancement of the high-density forming of the wiring circuit pattern or high-density mounting of the electronic components.

Shown in FIG. 2 is a production process drawing of a double sided flexible wired circuit board as a second embodiment of a double sided wired circuit board of the present invention. Referring to FIG. 2, the production method of the second embodiment of the double sided flexible wired circuit board will be described below.

In this method, the insulating layer 1 is prepared, first, as shown in FIG. 2(a). The same material as that of the insulating layer 1 of the first embodiment is used as the insulating layer 1.

Then, a through hole 2 is formed in the insulating layer 1, as shown in FIG. 2(b). The through hole 2 can be formed to have the same size and shape by the same method as in the first embodiment.

Thereafter, conductor layers 3 are formed in the form of the wiring circuit pattern on both sides of the insulating layer 1 by the semiadditive process, as shown in FIG. 2(c) to FIG. 2(g). At the same time as the forming of the conductor layers 3, the conductor portion 4 for providing electrical conduction between the conductor layers 3 is formed in the through hole 2 by filling conductive material in the through hole 2 with no substantial space therein.

Specifically, thin metal films 5 serving as a seed film are formed on the both sides of the insulating layer 1 and around the inside surface of the through hole 2, first, as shown in FIG. 2(c). The thin metal film 5 can be formed to have the same thickness in the same manner as in the first embodiment. Preferably, the thin metal films 5 are each formed by laminating a thin chromium film and a thin copper film in sequence by sputtering.

Then, as shown in FIG. 2(d), plating resists 7 are formed in a pattern inverted to the wiring circuit pattern on the surfaces of the thin metal films 5 formed on both sides of the insulating layer 1. Each plating resist 7 is formed in the inverted pattern to the wiring circuit pattern mentioned above, for example, by a known method of laminating a dry film photoresist on the thin metal film 5; exposing it to light; and developing it. The plating resist 7 is not formed in any area corresponding to the through hole 2.

Then, as shown in FIG. 2(e), the conductor layers 3 are formed on the surfaces of the thin metal films 5 exposed from the plating resists 7 and also the conductor portion 4 is formed to be filled in an interior space surrounded by the thin metal film 5 formed around the inside surface of the through hole 2.

When these conductor layers 3 and conductor portion 4 are formed, the conductor layers 3 are formed on the both lengthwise (vertical) ends of the conductor portion 4 as well, so that the both lengthwise (vertical) ends of the conductor portion 4 formed in the through hole 2 are continuous with the respective conductor layers 3.

The conductor layers 3 and the conductor portion 4 are formed of the same metal as in the first embodiment, preferably of copper. The conductor layers 3 and the conductor portion 4 are simultaneously formed by electrolytic plating, or preferably by electrolytic copper plating, though not particularly limited thereto. In the electrolytic copper plating, the same plating solution as in the first embodiment is used as the plating solution. The current density is also set to be in the same range as in the first embodiment.

Each of the conductor layers 3 has a thickness of e.g. 3-30µm, or preferably 5-15µm.

Thereafter, the plating resists 7 are removed and thereby the conductor layers 3 are produced in the form of the wiring circuit pattern, as shown in FIG. 2(f). The removal of the plating resists 7 is carried out by the known etching method, such as the chemical etching (wet etching) or by stripping.

Then, as shown in FIG. 2(g), all areas of the thin metal films 5, except areas thereof where the conductor layers 3 and the conductor portion 4 are formed, are removed. The removal of the thin metal films 5 is carried out by the known etching method such as, for example, the chemical etching (wet etching).

This can provide the result that the conductor portion 4 is formed in the through hole 2 with no substantial space therein and also formed to be integral with the respective conductor layers 3 in the form of the wiring circuit pattern. This can allow the electrical connection between the conductor layers 3 via the conductor portion 4.

Also, in the double sided wired circuit board of the second embodiment thus produced, the through hole 2 is solidly filled with the conductor portion 4 (or is filled to opening cross sectional portion thereof with the conductor portion 4), as is the case with the double sided wired circuit board of the first embodiment. This can allow the both lengthwise (vertical) ends of the conductor portion 4 to be used as component mounting portions, and as such can allow the forming of the wiring circuit pattern of the conductor layers 3 on the component mounting portions, as in the second embodiment, or the mounting of electronic components thereon, not shown. This can provide enhancement of the high-density forming of the wiring circuit pattern or high-density mounting of the electronic components.

It is to be added further that the double sided wired circuit board of the present invention is not limited to the illustrated embodiments, but includes other types of double sided wired circuit boards wherein the through hole formed in the insulating layer is filled with metal.

### EXAMPLES

While in the following, the present invention will be described in further detail with reference to Examples, the present invention is not limited to any Examples.

### EXAMPLE 1

An insulating layer formed of a polyimide film having a thickness of 25µm was prepared (Cf. FIG. 1(a)). Then, a through hole was formed in the insulating layer by laser processing, to have a circular truncated conic form that becomes narrower gradually from one side of the insulating layer to the other side of the same and has a diameter of 60µm on the one side and a diameter of 30µm on the other side and an angle θ of obliquity of 60° (Cf. FIG. 1(b)).

Then, thin metal films of thin copper films having a thickness of 0.2µm were formed on the both sides of the insulating layer and around the inside surface of the through hole by electroless copper plating (Cf. FIG. 1(c)). Thereafter, using electrolytic plating, conductor layers of copper foils having a thickness of 15µm were formed on surfaces of the thin metal films formed on both sides of the insulating layer and also the conductor portion formed of copper was formed to be filled in an interior space surrounded by the thin metal film formed around the inside surface of the through hole. The conductor layers were formed on both lengthwise ends of the conductor portion as well, so that the both lengthwise ends of the conductor portion formed in the through hole were continuous with the respective conductor layers (Cf. FIG. 1(d)).

In the electrolytic copper plating, a copper sulfate solution (UDYLITE VFII available from EBARA-UDYLITE CO. LTD.) was used as a plating solution, and the current density was set at 2A/dm².

Then, after an etching resist of a dry film photoresist was laminated on the each conductor layer, the etching resist was exposed to light and developed, to form the etching resist in the same pattern as the wiring circuit pattern (Cf. FIG. 1(e)). Thereafter, the conductor layers exposed from the etching resists and the thin metal films on which the conductor layers were laminated were also etched by the chemical etching (Cf. FIG. 1(f)). Thereafter, the etching resists were removed by the chemical etching (Cf. FIG. 1(g)). The double sided wired circuit board was obtained in the manner as mentioned above.

In this double sided wired circuit board, the wiring circuit patterns of the conductor layers were continuously formed on the both lengthwise ends of the conductor portion as well, and as such could allow the high-density forming of fine wiring circuit patterns.

### EXAMPLE 2

An insulating layer formed of a polyimide film having a thickness of 25µm was prepared (Cf. FIG. 2(a)). Then, a through hole was formed in the insulating layer by laser processing, to have a circular truncated conic form that becomes narrower gradually from one side of the insulating layer to the other side of the same and has a diameter of 60µm on the one side and a diameter of 30µm on the other side and an angle θ of obliquity of 60° (Cf. FIG. 2(b)).

Then, the thin metal films were formed on both sides of the insulating layer and around the inside surface of the through hole by laminating a thin chromium film having a thickness of 0.02µm and a thin copper film having a thickness of 0.1µm in sequence by sputtering (Cf. FIG. 2(c)). Thereafter, plating resists of dry film photoresists were formed in a pattern inverted to the wiring circuit pattern on the surfaces of the thin metal films formed on both sides of the insulating layer by laminating the dry film photoresists on the thin metal film; exposing them to light; and developing them (Cf. FIG. 2(d)). Then, the conductor layers having a thickness of 15µm were formed on the surfaces of the thin metal films exposed from the plating resists and also the conductor portion formed of copper was formed to be filled in an interior space surrounded by the thin metal film formed around the inside surface of the through hole. The conductor layers were formed on the both lengthwise ends of the conductor portion as well, so that the both lengthwise ends of the conductor portion formed in the through hole were continuous with the respective conductor layers (Cf. FIG. 2(e)).

In the electrolytic copper plating, a copper sulfate solution (TOP LUCINA α available from OKUNO CHEMICAL INDUSTRIES CO., LTD.) was used as a plating solution, and the current density was set at 2A/dm².

Thereafter, the plating resists were removed by the chemical etching (Cf. FIG. 2(f)) and, further, all areas of the thin metal films, except areas thereof where the conductor layers and the conductor portion were formed, were removed (Cf. FIG. 2(g)). The double sided wired circuit board was obtained in the manner as mentioned above.

In this double sided wired circuit board, the wiring circuit patterns of the conductor layers were continuously formed on the both lengthwise ends of the conductor portion as well, and as such could allow the high-density forming of fine wiring circuit patterns.

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A double sided wired circuit board comprising an insulating layer, and conductor layers formed on both sides of the insulating layer, wherein a through hole extending in a thickness direction of the insulating layer is formed in the insulating layer, and wherein the through hole is filled with a metal.

2. The double sided wired circuit board according to Claim 1, wherein the metal is formed by electrolytic plating.

3. The double sided wired circuit board according to Claim 1, wherein an end of the metal filled in the through hole serve as a component mounting portion.
